(19) **Europäisches Patentamt**

**European Patent Office**

**Office européen des brevets**

(11) **EP 1 097 107 B1**

(12) **EUROPEAN PATENT SPECIFICATION**

(45) Date of publication and mention
of the grant of the patent:
**01.03.2006 Bulletin 2006/09**

(51) Int Cl.:
*C01B 31/06* (2006.01)    *C30B 33/00* (2006.01)
*C30B 29/04* (2006.01)

(21) Application number: **99957159.9**

(22) Date of filing: **23.06.1999**

(86) International application number:
**PCT/IB1999/001174**

(87) International publication number:
**WO 1999/067171 (29.12.1999 Gazette 1999/52)**

(54) **A METHOD OF ALTERING THE COLOUR OF A MATERIAL**

METHODE ZUR ÄNDERUNG DER FARBE EINES MATERIALS

PROCEDE PERMETTANT DE MODIFIER LA COULEUR D'UNE MATIERE

(84) Designated Contracting States:
**CH DE FR GB LI SE**

(30) Priority: **24.06.1998 ZA 9805495**

(43) Date of publication of application:
**09.05.2001 Bulletin 2001/19**

(73) Proprietor: **Sellschop, Jacques Pierre Friedrich**
**Greenside 2193 (ZA)**

(72) Inventor: **Sellschop, Jacques Pierre Friedrich**
**Greenside 2193 (ZA)**

(74) Representative: **Benson, John Everett**
**J. A. Kemp & Co.,**
**14 South Square,**
**Gray's Inn**
**London WC1R 5JJ (GB)**

(56) References cited:
**EP-A- 0 014 528**      **EP-A- 0 316 856**
**EP-A- 0 615 954**      **US-A- 2 998 365**
**US-A- 5 084 909**

- **CHEMICAL ABSTRACTS, vol. 131, Columbus, Ohio, US; abstract no. 7616, UMEDA IWAO: "Coloring of gems by irradiation for fashion and health" XP002114835 & NIPPON AISOTOPU, HOSHASEN SOGO KAIGI RONBUNSHU, 23RD, B202/1-B202/7,1998,**
- **DAGAN R ET AL: "Optimization of gemstone irradiation in the IRR-1" NUCLEAR SOCIETIES OF ISRAEL TRANSACTIONS, VOL.16. JOINT MEETING 1990, HERZLIYA, ISRAEL, 17-18 DEC. 1990, pages 58-60, XP002114844 1990, Israel, Nucl. Soc. Israel, Israel**
- **DATABASE COMPENDEX [Online] ENGINEERING INFORMATION, INC., NEW YORK, NY, US VAVILOV V S ET AL: "Transmutational diamond doping by boron acceptor impurity" Database accession no. EIX95062479258 XP002114836 & SB KRATK SOOBSHCH FIZ AN SSSR;SBORNIK - KRATKIE SOOBSHCHENIYA PO FIZIKE AN SSSR MAR-APR 1994, no. 3-4, March 1994 (1994-03), pages 9-11,**
- **DATABASE WPI Section Ch, Week 8833 Derwent Publications Ltd., London, GB; Class K08, AN 88-230436 XP002114837 & JP 63 162600 A (NIPPON KOKAN KK), 6 July 1988 (1988-07-06)**

**Description**

## BACKGROUND OF THE INVENTION

This invention relates to a method of altering the colour of diamond. The diamond may be natural or synthetic diamond. Synthetic diamond is produced by high pressure/high temperature synthesis or by chemical vapour deposition.

Diamond is a material which is produced in nature as a colourless material or in various colours. In particular, blue coloration in diamond is due to the presence of boron atoms, whereas the yellow coloration in diamond is due to the presence of nitrogen in different structural forms. Synthetic diamonds are typically produced with a yellow colour due to the inclusion of nitrogen. The addition of boron in the growth capsule of high pressure/high temperature (HPHT) synthetic diamond produces blue coloration. Nitrogen can also be deliberately added in this HPHT growth process. Boron or nitrogen can similarly be added in the CVD growth process. Other selected atomic or molecular species can be added, as appropriate.

## SUMMARY OF THE INVENTION

According to the present invention, there is provided a method of altering the colour of a diamond, which comprises

exposing the diamond to irradiation of an energy suitable to cause photonuclear transmutation of selected atoms into other atoms and of an energy such as to excite a giant dipole resonance (GDR) in the diamond, the irradiation being such as either:

> (1) to cause transmutation of carbon atoms into boron atoms, thereby imparting a blue colour to the diamond; or
> (2) in the case of a nitrogen-containing yellow diamond, to cause transmutation of nitrogen atoms into carbon atoms thereby reducing the yellow colour of the diamond; and

reducing radiation damage in the diamond by annealing the diamond to restore the diamond lattice leaving the colour change due to the transmutation unaffected.

The selected atoms may be carbon atom and the irradiation of an 6ner- y. suitable to cause the photonuclear transmutation of carbon atoms into boron atoms, thereby imparting a blue colour to the material.

The selected atoms may be nitrogen which gives the diamond a yellow colour. The energy of the irradiation may be chosen to cause the photonuclear transmutation of nitrogen atoms into carbon atoms thereby reducing the yellow colour of the diamond. The reduction may be such as to bleach the diamond completely.

The colour alteration described above is achieved in an entirely controllable manner and cannot subsequently be removed.

If the diamond suffers any radiation damage during the treatment, such radiation damage may be annealed out. For example, if there is radiation damage in the diamond lattice structure, restoration, in whole or in part, of the lattice structure may be achieved by a particular annealing protocol or a combination of annealing protocols.

The irradiation is preferably achieved using photons. e.g. gamma rays. The photons, when used, may have a continuous distribution of energies with a well-defined specifically selected end-point (maximum) energy, or may be more nearly monochromatic with a well-defined energy width and median energy. Other irradiation sources such as electrons may be used.

The invention has application to the controlled and homogeneous colour change of diamond of all types, shapes and sizes, single crystal and polycrystalline, natural and synthetic. The synthetic diamond may be produced by high pressure/high temperature growth or chemical vapour deposition (CVD).

In one form of the invention, the selected atoms are carbon atoms and sufficient of these atoms are transmutated into boron to produce a blue colour. The minimum energy of radiation necessary to achieve a particular photonuclear reaction will vary according to the specific energetics of the reaction. Examples are provided hereinafter. Typically, the energy of the radiation will be in the range 16 MeV to 32 MeV.

The energy of the radiation is chosen to excite the giant dipole resonance (GDR) which leads to an enhancement of the boron production rate. The GDR is a broad resonance and bremsstrahlung can be produced by means of an electron accelerator such that the endpoint energy of the bremsstrahlung spectrum is above the region of the GDR providing thereby photons in the relevant energy range to excite the GDR. Certain advantages may be achieved by the use of monoenergetic (monochromatic) photons of selected energy, or by a defined window of photon energies of chosen energy width and median energy.

The energy of photon irradiation may be selected to be above the energy threshold for the transmutation reactions desired, and/or embrace the energy width of the GDR, or the endpoint photon energy may be selected to be high enough to enhance the photon flux in the GDR range while limiting unnecessary photons at higher energies that make a minor contribution to the transmutation yield.

The number of selected atoms which are photonuclear transmutated into other atoms depends on the degree of colour alteration desired.

## DESCRIPTION OF EMBODIMENTS

The invention relates to altering the colour of polycrystalline or single crystal diamonds. Diamonds can be coloured in an entirely controllable manner to varying degrees of blue using the method of the invention. This coloration is not a radiation damage effect but a true transmutation effect, so that once created, the blue colour cannot subsequently be annealed out. Similarly, the bleaching or un-colouring of yellowness in diamond is also a true transmutation effect and cannot subsequently be restored - it is stable. This transmutation technique alters the physical properties of diamond, such as the colour, and various applications can take advantage of this controlled effect. These would include, for example, changing in a controlled manner the optical transmission characteristics of diamond windows, improving them to match specific needs. This coloration or decoloration may be used to modify the colour and hence the optical transmission of diamond windows or for other applications where the colour of diamond is important.

Blue coloration may be achieved by exposing the diamond specimen to irradiation by photons of selected energy, thereby inducing the photonuclear reactions whereby carbon atoms are converted into boron atoms. The photonuclear reactions in question are:

$$^{12}C\ (\gamma,p)\ ^{11}B \qquad Q = -\ 15.972 \qquad MeV$$

and

$$^{12}C\ (\gamma,n)\ ^{11}C \qquad Q = -\ 18.7215 \qquad MeV$$

followed by

$$^{11}C \rightarrow\ ^{11}B\ +\ \beta^{+}$$

It is essential that the photon energy is selected to ensure that the desired photonuclear reaction leading to the formation of boron by the transmutation of carbon is energetically possible, since these are endothermic reactions. The photon energy is not selected just to be above the energy threshold so as to enable the reaction in question to take place, but is selected so as to be high enough to excite the giant dipole resonance (GDR) which will have as a consequence a substantially enhanced boron production rate. The GDR is a fundamental nuclear excitation mode characteristic of all nuclei, and is of substantial strength. The optimum selected irradiation energy spectrum of the photons for the nuclear transmutation of interest takes into account the number of photons in the highest yield part of the excitation function while reducing unnecessary exposure of the specimen to photons that produce less or minimal contribution to the transmutation yield while contributing to radiation damage.

The photons of GDR energies may be produced in the form of continuous radiation or bremsstrahlung, where the end-point (maximum) energy is selected so as to embrace the whole of the GDR structure. Alternatively an energy band of photons ("monochromatic photons") can be used where the spectrum of photons has a well-defined width and selected median energy.

The half-value thickness of diamond for photons of energy selected to excite the GDR (viz 20 - 25 MeV) is 13cm. Hence it is an important feature of this invention that due to the great penetrating power of the photons, the boron production is extremely uniform throughout the sample, and hence the coloration is extremely homogeneous even in the case of large diamonds. In the case of the very largest specimens there may be some advantage in rotating or tumbling the specimen in the photon beam.

It is another important feature of this invention that the degree of coloration can be very accurately controlled through the control of the dose of photons to which the specimen is subjected. The dose can be delivered incrementally with inspection of the degree of coloration achieved between individual increments, if appropriate.

It is another feature of this invention that radiation damage can be limited or the true lattice structure restored by a number of means. These include self-annealing at room temperature annealing at elevated temperatures both post-irradiation and during irradiation, low-temperature irradiation followed by rapid thermal annealing, laser annealing with or without thermally assisted annealing, resonant laser annealing with or without thermally assisted annealing, or combinations thereof.

The blue coloration is not due to radiation damage effects but is a true and irreversible transmutation of carbon to boron which cannot be annealed out. The degree of boronation and therefore the degree of blue coloration can be precisely controlled and once established, cannot he bleached or "lightened".

The same boronation photonuclear processes can be applied to synthetic high pressure/high temperature diamond and to CVD diamond.

This invention also has application to removing ("bleaching") or reducing the yellow colour of diamonds caused by the presence of nitrogen in the diamond. This can be achieved by exposing the diamond to irradiation by photons which gives rise to photonuclear reactions as follows:

$$^{14}N\ (\gamma,p)\ ^{13}C \qquad Q = -\ 7.549 \qquad MeV$$

and

$$^{14}N\ (\gamma,n)\ ^{13}N \qquad Q = -\ 10.553 \qquad MeV$$

followed by

$$^{13}N\ ->\ ^{13}C\ +\ \beta^{+}$$

The nitrogen is converted to carbon which is of course the host atom of the material. It is important to note that these nitrogen-bleaching reactions have endothermic Q-values which are well-separated from those of the photonuclear boronation reactions, so that the yellow-bleaching process can be effected without inducing boronation (blue coloration), if so desired by the appropriate selection of photon energies. Alternatively, both processes can by design be allowed to proceed simultaneously, the yellow-bleaching and the blue coloration of the diamond, exciting simultaneously the high yield GDR's of both the nitrogen transmutation reaction and the carbon transmutation reaction. If only the reduction of the yellowness is desired without the boronation, this will be in a photon energy regime where the nitrogen transmutation GDR is not excited and hence will proceed more slowly.

Once wholly or partially bleached of the yellow colour, the diamond cannot be unbleached. A sequence of bleaching a diamond of its yellow colour followed by making it blue can be achieved, or both can be achieved simultaneously.

As in the case of boronation by photonuclear reactions so also in the case of bleaching of the yellowness of diamonds by photonuclear reactions, annealing procedures as described above may be used.

As a consequence of the great penetrating power of the photons, used, the bleaching process proceeds in an extremely homogeneous way throughout the sample.

This photonuclear method for the conversion of nitrogen to carbon (the "bleaching process") is equally applicable to natural diamond, synthetic high pressure/high temperature diamond, to CVD diamond, and to polycrystalline diamond.

An important feature of this invention is that the use of energetic photons has as a consequence that the diamond does not have to be located for the purposes of irradiation in a vacuum system, such as for example that of the accelerator which produces the electrons and which in their turn produce photons. The diamond can be in air and will be readily accessed by the photon flux. It could equally well be located in a cryogenic facility for low-temperature irradiation. Similarly, the diamond could be located in an independent vacuum system or in a gas cell for the case of high temperature irradiation.

Another important feature of this invention is that many diamonds can be irradiated in the photon flux simultaneously. This photonuclear process can readily be adapted as an industrial process.

Other nuclear reactions besides the photon-induced one described hitherto are possible. Examples are:

(e,e' p)
(e,e' n)
(p,p' p) or (p,2p)

(p,p' n) or (p,pn)

Generally these are either inferior to or offer no significant advantages above the photon-induced reactions, although there may be situations where the electron-induced (or position-induced) reactions are advantageous.

The manner in which the invention is carried out could take, for example, the following form. An electron (linear) accelerator of chosen electron energy is run at an appropriately selected power level, with the electron beam focussed to a spot size of convenient dimensions on a carefully constructed single element or compound target designed for optimal bremsstrahlung production for the transmutation reactions in question.

The diamond specimen or specimens are mounted in close proximity to the bremsstrahlung source. They may be mounted in a vacuum environment with a (thin) window for transmission of the bremsstrahlung photons, or in air, or in a gas, generally inert, environment.

Provision may be made to irradiate the diamond(s) making up the target at room temperature, or at elevated temperature, or at low temperature during photon irradiation or after or both. Provision may simultaneously be made for laser irradiation or resonant laser irradiation during photon irradiation or after or both, together with or without simultaneous temperature selection of the diamond specimens under photon irradiation.

The photon flux may be monitored during irradiation by a counter/detector system such as, for example, a transmission ionisation chamber. Alternatively, or in addition, activation targets may be added to the diamond(s) target to participate in the same photon irradiation action. The electron current may also be monitored.

The unambiguous indicator of boronation of carbon in diamond, for example, is the radioactive decay of the $^{11}$C formed in the ($\gamma$,n) reaction. This has a unique decay signature of two co-linear photons each of 0,511MeV energy, with a half-life of 20 minutes.

As the penetration depth of the high energy photons used according to this invention is so large, the diamond irradiation target heed not be a single diamond but could readily be an assembly of diamonds.

**Claims**

1. A method of altering the colour of a diamond, which comprises
   exposing the diamond to irradiation of an energy suitable to cause photonuclear transmutation of selected atoms into other atoms and of an energy such as to excite a giant dipole resonance (GDR) in the diamond, the irradiation being such as either:

   (1) to cause transmutation of carbon atoms into boron atoms, thereby imparting a blue colour to the diamond; or
   (2) in the case of a nitrogen-containing yellow diamond, to cause transmutation of nitrogen atoms into carbon atoms thereby reducing the yellow colour of the diamond; and

   reducing radiation damage in the diamond by annealing the diamond to restore the diamond lattice leaving the colour change due to the transmutation unaffected.

2. A method according to claim 1 wherein the irradiation is achieved using photons.

3. A method according to claim 2 wherein the photons comprise gamma rays.

4. A method according to any one of claims 1 to 3 wherein the energy of the irradiation is such as to cause transmutation of carbon atoms into boron atoms according to the photonuclear reaction:

   $^{12}$C($\gamma$,p)$^{11}$B

5. A method according to claim 4 wherein the energy of the irradiation is such that the photonuclear reaction $^{12}$C ($\gamma$, p) $^{11}$B is a dominant reaction.

6. A method according to any one of claims 1 to 3 wherein the energy of the irradiation is such as to cause transmutation of carbon atoms into boron atoms according to the photonuclear reactions: $^{12}$C (y,n) $^{11}$C followed by $^{11}$C- > $^{11}$B +

7. A method according to any one of claims 1 to 3 wherein the energy of the irradiation is such as to cause transmutation of nitrogen atoms into carbon atoms according to the photonuclear reaction $^{14}$N ($\gamma$, p)$^{13}$C.

8. A method according to claim 7 wherein the energy of the irradiation is such that the photonuclear reaction: $^{14}$N ($\gamma$,

p) $^{13}$C is a dominant reaction.

9. A method according to any one of claims 1 to 3 wherein the energy of the irradiation is such as to cause transmutation of nitrogen atoms into carbon atoms according to the photonuclear reactions:

$^{14}$N ($\gamma$,n) $^{13}$N followed by $^{13}$N-> $^{13}$C + $\beta^+$.

10. A method according to any one of the preceding claims wherein the diamond comprises one or more of natural diamond, synthetic high pressure/high temperature diamond and CVD diamond.

**Revendications**

1. Procédé de modification de la couleur d'un diamant, comprenant l'exposition du diamant aux irradiations d'une énergie capable de provoquer la transmutation photo-nucléaire d'atomes choisis en d'autres atomes, et d'une énergie capable d'exciter une résonance géante dipolaire (GDR) dans le diamant, l'irradiation étant telle que soit:

(1) elle provoque la transmutation d'atomes de carbone en atomes de bore, donnant de cette façon une couleur bleue au diamant ; soit
2) dans le cas d'un diamant jaune contenant de l'azote, elle provoque une transmutation d'atomes d'azote en atomes de carbone atténuant de cette façon la couleur jaune du diamant ; et

réduisant les dommages dûs à la radiation dans le diamant en soumettant le diamant à un recuit pour restaurer le réseau du diamant laissant le changement de couleur dû à la transmutation inaltéré.

2. Procédé selon la revendication 1, dans lequel l'irradiation est obtenue en utilisant des photons.

3. Procédé selon la revendication 2, dans lequel les photons comprennent des rayons gamma.

4. Procédé selon l'une quelconque des revendications 1 à 3, dans lequel l'énergie de l'irradiation est telle qu'elle provoque la transmutation d'atomes de carbone en atomes de bore selon la réaction photo-nucléaire :

$^{12}$C($\gamma$,p)$^{11}$B.

5. Procédé selon la revendication 4, dans lequel l'énergie de l'irradiation est telle que la réaction photonucléaire $^{12}$C($\gamma$,p)$^{11}$B est une réaction dominante.

6. Procédé selon l'une quelconque des revendications 1 à 3, dans lequel l'énergie de l'irradiation est telle qu'elle provoque la transmutation d'atomes de carbone en atomes de bore selon les réactions photonucléaires : $^{12}$C($\gamma$,n)$^{11}$C suivie de $^{11}$C→$^{11}$B+$\beta^-$.

7. Procédé selon l'une quelconque des revendications 1 à 3, dans lequel l'énergie de l'irradiation est telle qu'elle provoque la transmutation d'atomes d'azote en atomes de carbone selon la réaction photonucléaire :

$^{14}$N($\gamma$,p)$^{13}$C.

8. Procédé selon la revendication 7, dans lequel l'énergie de l'irradiation est telle que la réaction photonucléaire $^{14}$N($\gamma$,p)$^{13}$C est dominante.

9. Procédé selon l'une quelconque des revendications 1 à 3, dans lequel l'énergie de l'irradiation est telle qu'elle provoque la transmutation d'atomes d'azote en atomes de carbone selon les réactions photonucléaires :

14N($\gamma$,n)13 suivie de 13N→13C+$\beta^+$.

10. Procédé selon l'une quelconque des revendications précédentes, dans lequel le diamant comprend un ou plusieurs diamants naturels, diamants synthétiques haute pression/haute température et des diamants obtenu par déposition de vapeur chimique (CVD).

**Patentansprüche**

1. Verfahren zum Verändern der Farbe eines Diamanten, welches umfasst,
   das Aussetzen des Diamanten einer Bestrahlung mit einer Energie, die geeignet ist, um eine photonukleare Transmutation von ausgewählten Atomen zu anderen Atomen zu verursachen und einer Energie, dergestalt dass eine Riesendipolresonanz (GDR) in dem Diamanten angeregt wird, wobei die Bestrahlung dergestalt ist, dass entweder:

   (1) Transmutation von Kohlenstoffatomen zu Boratomen verursacht wird, wobei dem Diamanten eine blaue Farbe verliehen wird oder
   (2) im Falle eines Stickstoff-haltigen, gelben Diamanten, dass Transmutation von Stickstoffatomen zu Kohlenstoffatomen verursacht wird, wobei die gelbe Farbe des Diamanten verringert wird und

   das Verringern von Strahlungsschäden in dem Diamanten durch Kühlen des Diamanten, um das Diamantkristallgitter wiederherzustellen, wobei die Farbänderung aufgrund der Transmutation unbeeinflusst bleibt.

2. Verfahren nach Anspruch 1, wobei die Bestrahlung unter Verwendung von Photonen erfolgt.

3. Verfahren nach Anspruch 2, wobei die Photonen Gammastrahlen umfassen.

4. Verfahren nach einem der Ansprüche 1 bis 3, wobei die Energie der Bestrahlung dergestalt ist, dass die Transmutation von Kohlenstoffatomen zu Boratomen verursacht wird gemäß der photonuklearen Reaktion: $^{12}C$ $(\gamma,p)$ $^{11}B$.

5. Verfahren nach Anspruch 4, wobei die Energie der Bestrahlung dergestalt ist, dass die photonukleare Reaktion $^{12}C$ $(\gamma,p)$ $^{11}B$ eine Hauptreaktion ist.

6. Verfahren nach einem der Ansprüche 1 bis 3, wobei die Energie der Bestrahlung dergestalt ist, dass die Transmutation von Kohlenstoffatomen zu Boratomen verursacht wird gemäß der photonuklearen Reaktionen: $^{12}C$ $(\gamma,n)$ $^{11}C$ gefolgt von $^{11}C \rightarrow {}^{11}B + \beta^-$.

7. Verfahren nach einem der Ansprüche 1 bis 3, wobei die Energie der Bestrahlung dergestalt ist, dass die Transmutation von Stickstoffatomen zu Kohlenstoffatomen verursacht wird gemäß der photonuklearen Reaktion: $^{14}N$ $(\gamma,p)$ $^{13}C$.

8. Verfahren nach Anspruch 7, wobei die Energie der Bestrahlung dergestalt ist, dass die photonukleare Reaktion: $^{14}N$ $(\gamma,p)$ $^{13}C$ eine Hauptreaktion ist.

9. Verfahren nach einem der Ansprüche 1 bis 3, wobei die Energie der Bestrahlung dergestalt ist, dass die Transmutation von Stickstoffatomen zu Kohlenstoffatomen verursacht wird gemäß der photonuklearen Reaktionen: $^{14}N$ $(\gamma,n)$ $^{13}N$ gefolgt von $^{13}N \rightarrow {}^{13}C + \beta^+$.

10. Verfahren nach einem der vorangehenden Ansprüche, wobei der Diamant einen oder mehrere von natürlichem Diamant, synthetischem Hochdruck-/Hochtemperatur-Diamant und CVD Diamant umfasst.